# EUROPEAN PATENT APPLICATION

(11) **EP 3 396 288 A1**
(43) Date of publication of application: **31.10.2018**
(21) Application number: 16877834.8
(22) Date of filing: 20.12.2016
(51) Int. Cl.: F28D 15/02, H01L 23/427, H05K 7/20

(54) **REFRIGERATION DEVICE FOR A POWER CONVERTER**

(30) Priority: 23.12.2015 ES 201531429 U
(71) Applicant: Alaz-Arima, S.L., 31110 Noain (Navarra) (ES)
(72) Inventor: YE, Zheng, Teda (Tianjin) 300457 (CN); AGUAS ALCALDE, Juan José, 31004 Pamplona (Navarra) (ES); HURTADO GARCÍA, Leire, 31015 Pamplona (Navarra) (ES); AZCARATE AZCONA, Adolfo, 31514 Valtierra (Navarra) (ES)
(74) Representative: Evens, Paul Jonathan
(86) International application number: PCT/ES2016/070913
(87) International publication number: WO 2017/109253

(57) **Abstract**

The present invention relates to a cooling device for a power converter comprising a plate (2) made of a thermally conductive material; and at least one conduit (3) containing therein a working fluid (5) which is selected to change from a liquid to gas phase, and vice versa, during operation. The plate (2) has at least one housing for holding the conduit (3), wherein a first lower portion of the conduit (3) is inserted into the plate (2), acting as an evaporator, and a second upper portion of each conduit (3) remains outside the plate (2), acting as a condenser.

## Description

### Field of the Art

The present invention belongs to cooling systems for cooling a power converter based on semiconductors.

### State of the Art

A power converter is a device based on power semiconductors, usually IGBTs, which has the purpose of converting electric energy between two different formats. Semiconductors generate heat during operation, and said heat must be discharged to keep the semiconductors within their range of operating temperature.

Heat sinks that are coupled with the components are known. A heat sink removes heat from the component that it cools and discharges it to the outside air, generally in a passive manner. To that end, they have a plate which is coupled to the semiconductor and contains fins to increase the contact surface with air. They are usually made of aluminum as it is light weight, although they can also be made of copper as it has a better thermal conductivity. In some applications, the cooling it achieves is not sufficient and it requires incorporating a fan which actively forces the entry of air between the fins to improve heat discharge.

In more demanding applications, heat cannot be discharged at the point where it is generated and must be transferred to another more convenient location for dissipation. This transport of the generated heat to the discharge point is performed by means of a hydraulic circuit made up of a large number of components such as: a recirculation pump, a heat exchanger, ducts, hydraulic connections, a transport fluid, etc.

However, the existing solutions have limitations. At times, the heat generated in the components is too much to enable using heat sinks having reasonable dimensions. Additionally, cooling the component by means of a fluid requires recirculation pumps and their installation is very complex and takes up a lot of space. Furthermore, the ducts usually have various connections, increasing the possibility of there being leakages. All this reduces assembly reliability by increasing possibility of malfunction.

In active cooling, i.e., cooling incorporating electromechanical elements, the power consumption of the fans, pumps, etc., must be taken into account.

### Object of the Invention

The object of the present invention is a device for discharging heat generated by the semiconductors of a power converter.

The device comprises one or more, preferably tubular, conduits extending from the point where heat is generated to the discharge point, replacing the conventional hydraulic circuit. Said conduits contain therein a fluid which undergoes a phase change, transporting heat from one point to another in a passive manner without requiring a drive pump.

The space required for cooling is significantly reduced by eliminating the recirculation pump and the exchanger which are usually bulky elements.

On the other hand, since the hydraulic connections between the different components of the system are dispensed with, the possibility of leakages therein, and therefore the possibility of malfunctions and costly breakdowns, is significantly reduced.

The proposed solution simplifies the cooling system by eliminating components, and therefore increasing assembly reliability.

The object of the invention does not require any external energy consumption. As mentioned, the transport of heat is performed by means of the phase change of the fluid and the effect of gravity. Passive systems of this type, i.e., those performing their function without any electric consumption are particularly indicated for energy producing units, such as wind turbines, for example.

The invention is intended for simplifying the cooling system, saving space, and replacing active cooling elements.

The devised configuration is advantageously adapted to a power converter for discharging the generated heat. The present cooling device therefore includes a plate made of a thermally conductive material and one or more conduits containing therein a working fluid selected so that, during operation, it changes from a liquid to gas phase, and vice versa. The plate has housings for holding the conduits where a first lower portion of each conduit is inserted into the plate, acting as an evaporator, and a second upper portion of each conduit remains outside the plate, acting as a condenser.

Optionally, the housing present inside the plate intended for holding the first lower portion of the conduit can extend to form a chamber common to several conduits.

Optionally, the inner leak-tight chamber can allow direct contact of the working fluid with the semiconductor of the power converter for cooling same. The fluid will be selected to allow contact with the surface to be cooled of the semiconductor.

Optionally, the second upper portion of the conduits extends, forming a chamber common to several conduits.

The conduit is preferably sealed at one end. Optionally, the conduit is sealed at both ends.

Optionally, the device comprises at least two conduits, where each conduit is sealed at both ends, and where the working fluid contained in each conduit has a different boiling point.

Optionally, the working fluid inside the conduit is subjected to a pressure greater than the atmospheric pressure.

Optionally, in some embodiments the cooling device includes a plurality of fins coupled to the second portion of the conduits to increase the surface of the condenser.

Optionally, these fins can be part of the sealing of the end of the conduit.

In some embodiments, the fins are preferably metal fins.

In some embodiments, the plate is preferably a metal plate.

Optionally, the conduits comprise end segments made of a metal material and an intermediate segment made of a flexible and electrically insulating material.

Optionally, the conduits are screwed into the housings of the plate.

### Description of the Drawings

Figure 1 shows a diagram depicting the cooling device in which the tubular conduit is coupled to the semiconductor by means of a metal plate.
Figure 2 shows the detail of the end of a tubular conduit with fins.

### Detailed Description of the Invention

The object of the invention is a device for discharging heat, replacing the mentioned hydraulic circuit with one or more, preferably tubular, conduits that will extend from the point where heat is generated to the discharge point.

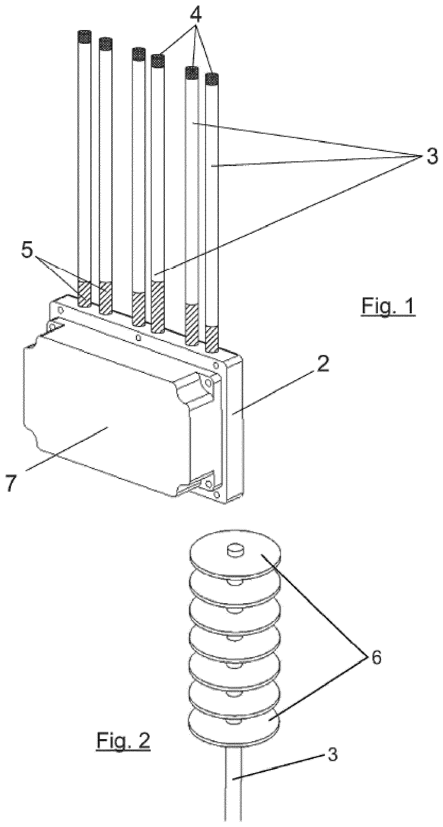

In the embodiment of the invention shown in Figure 1, the power semiconductor (7) is coupled to a metal plate (2) into which the preferably tubular-shaped conduit (3) is inserted.

The conduit (3) can be inserted completely into the metal plate (2) or can be inserted partially, for example, being placed against one of the side faces of the metal plate (2) .

A fluid (5) performs a phase change-based thermodynamic cycle inside the conduit (3). The lower part of the conduit (3) (referred to as evaporator) receives the heat to be dissipated and the fluid in liquid phase evaporates and transforms into vapor. Due to the difference in densities existing between the liquid and vapor state of all fluid, said vapor moves upward to the higher and colder part of the conduit (3) (referred to as condenser) where it condenses, giving off latent heat, and again moving downward by gravity to the lower part. The fluid repeats this cycle over and over again, a quick heat transfer in one direction from top to bottom thus being obtained.

The metal plate (2) is preferably selected with a high coefficient of thermal conductivity which allows a good heat transfer between the semiconductor (7) and the evaporator of the conduit (3). It can be made of aluminum or copper, for example.

Its dimensions as well as the dimensions of the conduit (3) will be adapted according to the power to be dissipated and the environmental conditions of the surroundings. Likewise, silicones with high thermal conductivity can be used, for example, for the coupling of the power semiconductor (7) to the metal plate (2), as well as of the conduit (3) in the housing thereof inside the metal plate (2). The manufacturing tolerances of the conduit (3) and the plate (2) as well as the roughness of the different materials selected for proper heat transfer must be studied in detail.

The conduit (3) must be selected for each application based on its fundamental parameters: material, thickness, length, etc. The material can be copper, for example.

If the material of the metal plate (2) and the conduit (3) are of different materials, the expansions of both must be taken into account to assure maximum contact in the entire range of working temperatures.

The working pressure of the conduit (3) must also be considered when determining the material and the thickness so that there will be no deformations which may reduce heat transfer.

The hermetic seal (4) must assure leak-tightness of the conduit (3) to the selected design conditions. Seals made by compression, hydraulic seals, seals with epoxy resins, etc., can be used, for example.

Alternatively, the conduit (3) could be sealed against the metal plate where, in this case, the metal plate would be the one that perform the function of an evaporator. Furthermore, in this case, an opening can be made on the plate (2) from the chamber to the support area of the semiconductor (7), so that the fluid is in direct contact with the semiconductor (7), reducing thermal resistance and therefore improving heat transfer. The attachment between the semiconductor (7) and the plate (2) must be sealed to maintain the leak-tightness of the fluid.

The working fluid (5) can be a coolant fluid, for example R-134-a or the like.

Figure 2 shows the possible embodiment in which metal fins (6) will be installed in the part of the condenser of the conduit (3) for the purpose of providing more surface for heat exchange between the conduit (3) itself and the outside air. Said fins (6) can be, for example, corrugated metal plates or flat discs inserted, welded, or embedded in the conduit (3) itself, arranged horizontally, vertically, in a spiral, etc. The main function of these fins (6) is to increase the surface for passive heat transfer with respect to the air. Alternatively, the fins could be built as a single assembly and with different shapes. In this case, the conduit (3) could be sealed against contra this assembly which would perform the function of a condenser.

According to a possible embodiment, when the conduits (3) comprised in the cooling device are at least two in number, each with both ends sealed, the working fluids (5) contained in the conduits (3) have a different boiling point. Using different working fluids (5) with different boiling points keeps the power semiconductor (7) within its optimum range of operation.

According to a possible embodiment, the conduits (3) comprise end segments made of a metal material and an intermediate segment made of a flexible and electrically insulating material. For example, the conduits (3) can be a flexible plastic material; this provides two significant advantages when cooling the power semiconductor (7), one on hand, plastic is an electrically insulating material which prevents possible electric leakages of the element to be cooled, and on the other hand, greater flexibility is provided to the cooling device during installation; i.e., making it possible to place same in spaces in which it would be impossible to place rigid or non-flexible conduits (3) due to the dimensions or configuration of the spaces for installing the devices, for example.

## Claims

1. A cooling device for a power converter comprising:
- a plate (2) made of a thermally conductive material;
- at least one conduit (3) containing therein a working fluid (5) which is selected to change from a liquid to gas phase, and vice versa, during operation;
**characterized in that** the plate (2) has at least one housing for holding the conduit (3), wherein a first lower portion of the conduit (3) is inserted into the plate (2), acting as an evaporator, and a second upper portion of each conduit (3) remains outside the plate (2), acting as a condenser.

2. The cooling device according to claim 1, **characterized in that** the housing of the plate (2) for holding the first lower portion of the conduit (3) extends, forming a chamber common to several conduits (3).

3. The cooling device according to claim 2, **characterized in that** the inner leak-tight chamber allows direct contact of the working fluid with at least one semiconductor (7) of the power converter.

4. The cooling device according to any of the preceding claims, **characterized in that** the second upper portion of the conduits (3) extends, forming a chamber common to several conduits (3).

5. The cooling device according to claim 1, **characterized in that** the conduit (3) is sealed at one end.

6. The cooling device according to claim 1, **characterized in that** the conduit (3) is sealed at both ends.

7. The cooling device according to the preceding claim, **characterized in that** it comprises at least two conduits (3), the working fluid (5) contained in each conduit (3) having a different boiling point.

8. The cooling device according to any one of the preceding claims, **characterized in that** the working fluid (5) inside the conduit (3) is subjected to a pressure greater than the atmospheric pressure.

9. The cooling device according to any one of the preceding claims, **characterized in that** it comprises a plurality of fins (6) coupled to the second portion of the conduit (3).

10. The cooling device according to claim 9, **characterized in that** the fins (6) include an upper seal of the conduit (3).

11. The cooling device according to claim 9, **characterized in that** the fins (6) are metal fins.

12. The cooling device according to any one of the preceding claims, **characterized in that** the conduit (3) is tubular.

13. The cooling device according to any one of the preceding claims, **characterized in that** the plate (2) is a metal plate.

14. The cooling device according to any one of the preceding claims, **characterized in that** the conduits (3) are screwed into the housings of the plate (2).

15. The cooling device according to any one of the preceding claims, **characterized in that** the conduits (3) comprise end segments made of a metal material and an intermediate segment made of a flexible and electrically insulating material.
